# EUROPEAN PATENT APPLICATION

(11) **EP 1 126 502 A1**
(43) Date of publication of application: **22.08.2001**
(21) Application number: 01301427.9
(22) Date of filing: 19.02.2001
(51) Int. Cl.: H01J 37/09, G21K 5/10, C03C 25/12

(54) **Method and system for shielding secondary X-rays from an electron beam irradiating unit**

(30) Priority: 18.02.2000 JP 2000040438
(71) Applicant: SHIN-ETSU CHEMICAL CO., LTD., Chiyoda-ku Tokyo (JP)
(72) Inventor: Ohba, Toshio c/o Shin-Etsu Chemical Co., Ltd., 2-13-1, Isobe, Annaka-shi, Gunma-ken (JP); Kawada, Nobuo c/o Shin-Etsu Chemical Co., Ltd., 2-13-1, Isobe, Annaka-shi, Gunma-ken (JP); Ueno, Masaya, c/o Shin-Etsu Chemical Co., Ltd., 2-13-1, Isobe, Annaka-shi, Gunma-ken (JP)
(74) Representative: Stoner, Gerard Patrick

(57) **Abstract**

In connection with a unit (3) for irradiating electron beams to a curable coating on a filament (1) for curing the coating, x-ray shielding tubes (6 and 7) are disposed upstream of an inlet (3a) and downstream of an outlet (3b) of the irradiating unit (3), respectively, for shielding secondary x-rays resulting from the electron beam irradiation. Secondary x-rays emanating from electron beams irradiated to the curable coating on the filament can be shielded in a simple way. The invention helps establish a safe working environment without detracting from process efficiency.

## Description

This invention relates to a method and system for shielding secondary x-rays emanating from a unit for irradiating electron beams to a curable coating on a filament such as an optical fiber for curing purposes.

Optical communications fibers include a variety of types such as quartz glass, multi-component glass and plastic fibers. In reality, quartz glass fibers are vastly used in a wide variety of applications because of their light weight, low loss, high durability and high transmission capacity. Since quartz glass fibers are very thin and sensitive to external factors, quartz glass fibers for optical communications are generally of the construction that a quartz glass fiber which is spun from a melt is coated with a liquid curable resin capable of curing to a soft state, the coating is cured to form a primary coating, and the primary coating is protected with a secondary coating using a liquid curable resin capable of curing to a hard state. This is generally designated a coated optical fiber or simply optical fiber. A tape element is fabricated by bundling several, typically four, optical fibers and coating the bundle with a taping material, followed by curing.

Typical of the coating materials are urethane acrylate base ultraviolet-curable resin compositions. As disclosed in JP-B 1-19694 and Japanese Patent Nos. 2,522,663 and 2,547,021, liquid UV-curable resin compositions comprising a urethane acrylate oligomer, a reactive monomer, and a polymerization initiator are known. To meet the recent demand for increasing the drawing speed of optical fibers for productivity improvement purposes, the UV curing system can find no solution other than the use of an increased number of UV lamps. This has a limit when curing is effected in a limited space. Curing by irradiation of electron beams is thus of great concern.

The curing method based on electron beam irradiation, however, suffers from the problem of secondary x-ray leakage. Japanese Patent No. 2,541,997 discloses electron beams (EB) as exemplary actinic energy radiation, but does not refer to an electron beam irradiating unit and the shielding of secondary x-rays emanating therefrom.

Prior art known electron beam irradiating units are mostly intended for the irradiation on wide sheet-like webs. For the electron beam irradiating unit dealing with a sheet-like web, a countermeasure for preventing secondary x-rays from leaking out of the irradiating unit can be contemplated. For instance, guide rolls are disposed at an inlet and an outlet of the irradiating unit for curling the sheet-like web so that the inlet and the outlet are not coplanar with the electron beam irradiating zone.

However, when a filament or small-gage elongate member such as an optical fiber is coated with a curable coating material over its entire surface, guide rolls for changing the travel direction cannot be used because they can damage the coating. It was then unlikely for simple means to shield secondary x-rays. A large size shield structure enclosing the overall system was necessary.

An object of the invention is to provide a simple method and system for shielding secondary x-rays emanating from a unit for irradiating electron beams to a curable coating on a filament such as an optical fiber or optical fiber tape for curing purposes.

It has been found that in connection with a unit for irradiating electron beams to a curable coating on a filament for curing the coating, secondary x-rays resulting from the electron beam irradiation can be effectively shielded against leakage simply by disposing x-ray shielding tubes upstream of an inlet and downstream of an outlet of the irradiating unit, respectively.

In one aspect, the invention provides a method for shielding secondary x-rays from a unit for irradiating electron beams to a curable coating on a filament for curing the coating when the coated filament passes from an inlet to an outlet of the irradiating unit. The method involves the step of disposing x-ray shielding tubes upstream of the inlet and downstream of the outlet of the irradiating unit, respectively, thereby shielding secondary x-rays resulting from the electron beam irradiation.

In another aspect, the invention provides a system for applying and curing a coating on a filament, comprising an applicator for applying an electron beam-curable coating material onto a filament; a unit for irradiating electron beams to the coating on the filament for curing the coating when the coated filament passes from an inlet to an outlet of the irradiating unit; means for winding up the filament with the cured coating; and means for moving the filament through the applicator and the irradiating unit to the wind-up means. The system further includes x-ray shielding tubes extending upstream of the inlet and downstream of the outlet of the irradiating unit, respectively. The filament is typically an optical fiber or optical fiber tape.

The invention is characterized in that a pair of x-ray shielding tubes are disposed upstream of the inlet and downstream of the outlet of the electron beam irradiating unit, respectively. In one preferred embodiment, one x-ray shielding tube disposed upstream of the inlet of the irradiating unit extends to an applicator for applying the curable coating to the filament, that is, one x-ray shielding tube covers the path through which the filament having the curable (or uncured) coating applied thereon travels from the applicator to the irradiating unit. The other x-ray shielding tube disposed downstream of the outlet of the irradiating unit extends from the irradiating unit to a transition where the filament with the cured coating changes its travel direction. Then secondary x-rays resulting from electron beam irradiation and leaking upstream and downstream of the irradiating unit can be effectively shielded in a simple way.

### BRIEF DESCRIPTION OF THE DRAWINGS

The above and other objects, features and advantages of the invention will be better understood by reading the following description taken in conjunction with the accompanying drawings.

FIG. 1 schematically illustrates a system for applying and curing a coating on a filament according to one embodiment of the invention.

FIG. 2 is an enlarged schematic view of the coating applicator in FIG. 1.

FIG. 3 is an enlarged schematic view of the electron beam irradiating unit in FIG. 1.

The method for shielding secondary x-rays from an electron beam irradiating unit according to the invention is described in detail. An electron beam-curable type coating material is applied to a filament such as an optical fiber or optical fiber tape. The coated filament passes through an electron beam irradiating unit from an inlet to an outlet thereof where electron beams are irradiated to the curable coating on the filament for curing the coating. According to the invention, a pair of x-ray shielding tubes are disposed upstream of the inlet and downstream of the outlet of the electron beam irradiating unit, respectively, for shielding secondary x-rays emanating from the inlet and outlet of the irradiating unit.

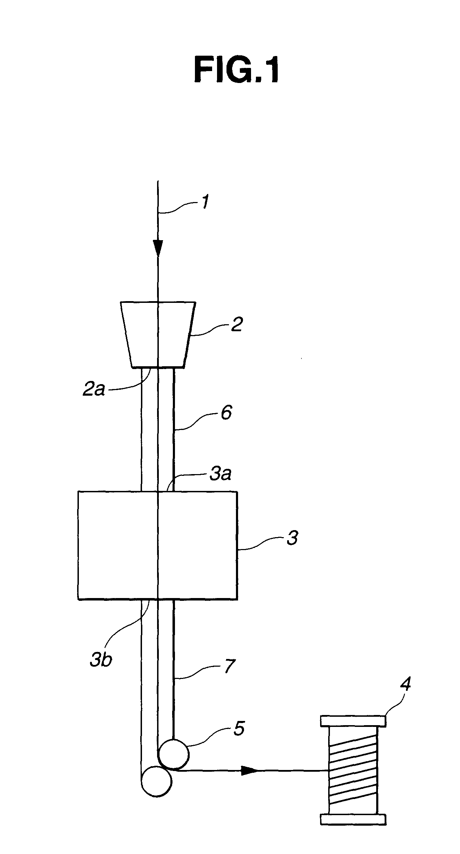

Referring to FIG. 1, there is illustrated one exemplary coating/curing system for use in the practice of the above method. The system includes a coating applicator 2 for applying an electron beam-curable type coating material to a length of filament 1, an electron beam irradiating unit 3 disposed downstream of the applicator 2 for irradiating electron beams to the coating on the filament 1 for curing the coating, and a take-up means in the form of a take-up bobbin 4 disposed downstream of the irradiating unit 3 for winding up the cured coating-bearing filament 1. Guide rolls 5 are disposed between the irradiating unit 3 and the take-up means 4 for turning the travel direction of the filament 1 from the straight path passing through the applicator 2 and the irradiating unit 3 toward the take-up means 4. Though not illustrated, the system further includes a drive means for moving the filament along the path at a predetermined speed.

According to the invention, a pair of x-ray shielding tubes 6 and 7 are provided. One x-ray shielding tube 6 is extended between an outlet 2a of the applicator 2 and an inlet 3a of the irradiating unit 3 so that the filament 1 having the curable coating applied thereon in the applicator 2 passes through the tube 6 before entry to the irradiating unit 3. The other x-ray shielding tube 7 is extended between an outlet 3b of the irradiating unit 3 and the transition of the filament path, that is, the guide rolls 5 so that the filament 1 passes through the tube 7 when it moves from the irradiating unit outlet 3b to the guide rolls 5. At the guide rolls 5, the filament changes its travel direction and is exposed to the ambient atmosphere before it is wound up on the take-up means 4.

In this way, one x-ray shielding tube disposed upstream of the inlet of the irradiating unit extends to an applicator for applying the curable coating to the filament, that is, one x-ray shielding tube covers the path through which the filament having the curable (or uncured) coating applied thereon travels from the applicator to the irradiating unit. The other x-ray shielding tube disposed downstream of the outlet of the irradiating unit extends from the irradiating unit to a transition where the filament with the cured coating changes its travel direction. This ensures the effective shielding of secondary x-rays resulting from electron beam irradiation and leaking upstream and downstream of the irradiating unit.

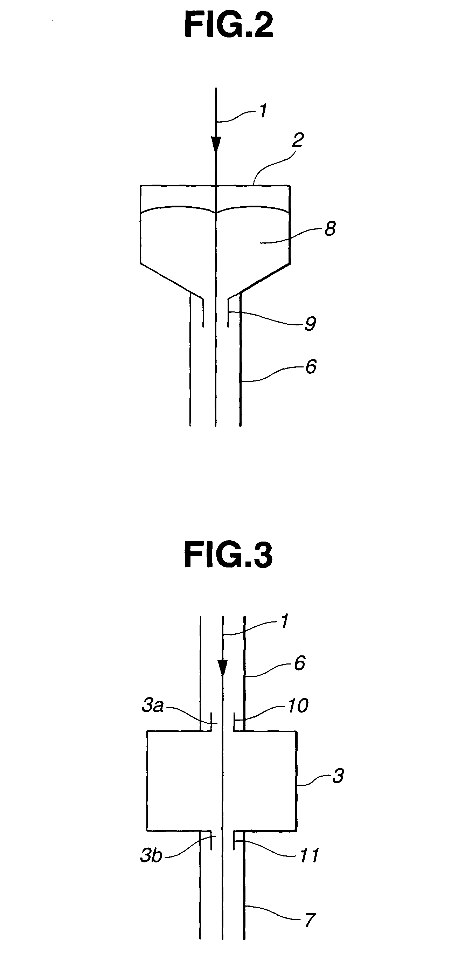

FIG. 2 is an enlarged view of the coating applicator 2 in FIG. 1. The applicator 2 contains therein an electron beam-curable coating material 8 and is designed to apply the coating material 8 to the filament 1 to a predetermined thickness. One end of the upstream shielding tube 6 is coupled to the applicator 2 at the bottom. The applicator 2 includes an annular flange 9 at the bottom over which the upstream shielding tube 6 is telescopically fitted. The flange 9 assists in shielding of secondary x-rays.

FIG. 3 is an enlarged view of the electron beam irradiating unit 3. The other end of the upstream shielding tube 6 is coupled to the irradiating unit 3 at the top or inlet 3a, and one end of the downstream shielding tube 7 is coupled to the irradiating unit 3 at the bottom or outlet 3b. The irradiating unit 3 includes annular flanges 10 and 11 at the inlet 3a and outlet 3b, over which the shielding tubes 6 and 7 are telescopically fitted, respectively. The flanges 10 and 11 assist in shielding of secondary x-rays so that any leakage of secondary x-rays is prevented even when gaps are formed between the shielding tubes 6, 7 and the irradiating unit 3.

To fully shield secondary x-rays resulting from electron beam irradiation, a dual tube structure as illustrated above is desirably provided at each of the connections of the shielding tubes to the coating applicator, the inlet and outlet of the irradiating unit, and the transition where the filament with the cured coating changes its travel direction.

The shielding tubes used for the shielding of secondary x-rays are preferably cylindrical although tubes of elliptical or rectangular cross-sectional shape may also be used insofar as the objects are achievable. The tubes are usually made of metals such as lead, copper, iron and zinc and alloys thereof although any material having x-ray shielding effects is useful.

The inner diameter of the shielding tube is not critical as long as the filament does not contact the inner wall when it passes therethrough. Usually the shielding tube has an inner diameter of about 0.1 to 100 mm, and preferably about 0.5 to 20 mm.

Each shielding tube may be structured such that it can be divided into two sections for allowing the filament to be smoothly set in the system.

The coating material applied to the filament, typically optical fiber or optical fiber tape, may be either a primary or a secondary coating material. Well-known coating materials based on electron beam-curable resins are useful. The electron beam-curable resins are those having functional groups capable of radical polymerization upon exposure to electron beams, and desirably compounds having at least one radical polymerizable (meth)acryloyl groups per molecule. The resins preferably have a viscosity in the range of about 500 to 10,000 centipoise at 25°C for workability and compatibility with optical fiber manufacturing conditions, and especially in the range of about 500 to 4,000 centipoise at 25°C under high-speed manufacturing conditions.

Such coating materials can be cured upon exposure to electron beams. The cured coating serving as the primary coating should desirably have a Young's modulus of up to 2 MPa for protecting the optical fiber from micro-bending due to external forces and temperature changes. The cured coating serving as the secondary coating should desirably have a Young's modulus of at least 4 MPa for reinforcing the optical fiber.

It is possible to apply the primary coating material to an optical fiber, apply the secondary coating material immediately thereafter, and then irradiate electron beams. This is effective for minimizing a transmission loss of the optical fiber and advantageous in simplifying the process.

The invention is also applicable to the manufacture of optical fiber tape. A tape element is generally fabricated by bundling several, typically four or eight, optical fibers on which the primary and secondary coating materials have been applied and cured, and coating the bundle with a taping material, followed by curing. The taping material is based on a resin having a relatively high Young's modulus, desirably of at least 4 MPa.

The electron accelerating voltage affects the quantity of secondary x-rays such that the lower the accelerating voltage, the less becomes the quantity of secondary x-rays. The accelerating voltage also affects the penetration depth of electrons. In order that electrons penetrate to the depth in the coating, the accelerating voltage should desirably be about 30 to 180 kV and more desirably about 60 to 150 kV. An accelerating voltage below 30 kV has a possibility that the coating material be not fully cured to the depth. Above 180 kV, not only the quantity of secondary x-rays generated, but also the transmission loss of the optical fiber may increase.

The dose of electron beams is determined by the electric current conducted through the electron gun filament and the processing speed. Usually the resin can be cured by irradiating electron beams in a dose of 10 to 40 kGy. To comply with a high speed of drawing, the electric current value is increased in proportion to the processing speed.

According to the invention, secondary x-rays emanating from electron beams irradiated to a curable coating on a filament can be shielded in a simple way. The invention helps establish a safe working environment without detracting from process efficiency.

Japanese Patent Application No. 2000-040438 are incorporated herein by reference.

Although some preferred embodiments have been described, many modifications and variations may be made thereto in light of the above teachings. It is therefore to be understood that the invention may be practiced otherwise than as specifically described.

## Claims

1. In connection with a unit for irradiating electron beams to a curable coating on a filament for curing the coating when the coated filament passes from an inlet to an outlet of the irradiating unit,
a method for shielding secondary x-rays from the electron beam irradiating unit, comprising the step of disposing x-ray shielding tubes upstream of the inlet and downstream of the outlet of the irradiating unit, respectively, thereby shielding secondary x-rays resulting from the electron beam irradiation.

2. The method of claim 1 wherein the x-ray shielding tube disposed upstream of the inlet of the irradiating unit extends to an applicator for applying the curable coating to the filament, thereby shielding secondary x-rays leaking upstream of the irradiating unit.

3. The method of claim 1 wherein the x-ray shielding tube disposed downstream of the outlet of the irradiating unit extends to a transition where the filament with the cured coating changes its travel direction, thereby shielding secondary x-rays leaking downstream of the irradiating unit.

4. The method of claim 1 wherein the filament is an optical fiber or optical fiber tape.

5. A system for applying and curing a coating on a filament, comprising
an applicator for applying an electron beam-curable coating material onto a filament,
a unit for irradiating electron beams to the coating on the filament for curing the coating when the coated filament passes from an inlet to an outlet of the irradiating unit,
means for winding up the filament with the cured coating, and
means for moving the filament through the applicator and the irradiating unit to the wind-up means,
the system further including x-ray shielding tubes disposed upstream of the inlet and downstream of the outlet of the irradiating unit, respectively.

6. A method of providing a coating on a filament comprising curing a curable coating material on the filament by electron beam irradiation in an irradiating unit, characterised by passing the filament through tubular x-ray shielding extensions of the inlet and outlet of the irradiating unit to shield secondary x-rays resulting from the electron beam irradiation.
